# EUROPEAN PATENT APPLICATION

(11) **EP 4 848 403 A1**
(43) Date of publication of application: **02.12.2026**
(21) Application number: 25217674.8
(22) Date of filing: 21.11.2025
(51) Int. Cl.: H01M 10/42, G01R 31/392

(54) **BATTERY MEASUREMENT DEVICE**

(30) Priority: 28.05.2025 KR 20250069967
(71) Applicant: Hyundai Motor Company, Seoul 06797 (KR); Kia Corporation, Seoul 06797 (KR); Pusan National University Industry-University Cooperation Foundation, Busan 46241 (KR)
(72) Inventor: LEE, Yong Seok, 18280 Hwaseong-si, Gyeonggido (KR); PARK, Je Sik, 18280 Hwaseong-si, Gyeonggido (KR); SEO, Jeong Hyun, 18280 Hwaseong-si, Gyeonggido (KR); SEO, Im Sul, 18280 Hwaseong-si, Gyeonggido (KR); LIM, Chung Bum, 18280 Hwaseong-si, Gyeonggido (KR); LEE, Hyun Beom, 18280 Hwaseong-si, Gyeonggido (KR); SEONG, Ju Yeong, 18280 Hwaseong-si, Gyeonggido (KR); LEE, Joo Young, 18280 Hwaseong-si, Gyeonggido (KR); HA, Seong Hyeok, 51203 Changwon-si, Gyeongsangnam-do (KR); KIM, Seong Yoon, 46300 Busan (KR); SHIN, Heon Cheol, 48039 Busan (KR)
(74) Representative: Viering, Jentschura & Partner mbB Patent- und Rechtsanwälte

(57) **Abstract**

A battery measurement device is disclosed. The device includes a fixing part configured to fix a battery including an electrode and an electrolyte, a first measurement part disposed at one side of the fixing part and configured to contact one surface of the battery, and a second measurement part disposed at the other side of the fixing part and configured to contact the other surface of the battery. The first measurement part includes a first electrode bar member and a first conductive wire member fixed to one side of the first electrode bar member. The first conductive wire member includes a body region and a plurality of branch regions extending from the body region and spaced apart from one another.

## Description

### CROSS-REFERENCE TO RELATED APPLICATION

This application claims priority to and the benefit of Korean Patent Application No. 10-2025-0069967 filed in the Korean Intellectual Property Office on May 28, 2025, the entire contents of which are incorporated herein by reference.

### TECHNICAL FIELD

The present disclosure relates to a battery measurement device, and more particularly, to a battery measurement device capable of being used to test performance of an all-solid-state battery.

### BACKGROUND ART

An all-solid-state battery refers to a battery in which an electrolyte, which mediates a flow of electric current, is in a solid state. The all-solid-state battery attracts attention as a next-generation battery because the all-solid-state battery has advantages in terms of high energy density, long lifespan, miniaturization, weight reduction, and the like.

Meanwhile, there are various methods of measuring the performance of the all-solid-state batteries, and examples of the methods include a method of measuring the performance of the all-solid-state battery by measuring impedance of the all-solid-state battery.

However, in the related art, there is a problem in that reliability in measuring impedance is degraded by high inductance caused by a structure of the all-solid-state battery, which is a target to be measured, during the process of measuring the impedance of the all-solid-state battery. This problem is particularly prominent during a process of measuring the impedance of the all-solid-state battery in a high-frequency range.

### SUMMARY

The present disclosure has been made in an effort to improve reliability in measuring impedance of a battery that is a target to be measured.

The present disclosure has also been made in an effort to ensure more stable electrical connection between an electrode of a battery and a device for measuring physical properties of the battery.

In order to achieve the above-mentioned objects, one aspect of the present disclosure provides a battery measurement device including: a fixing part configured to fix a battery B including an electrode E and an electrolyte S; a first measurement part provided at one side of the fixing part and configured to come into contact with one surface of the battery B; and a second measurement part provided at the other side of the fixing part and configured to come into contact with the other surface of the battery B, in which the first measurement part includes: a first electrode bar member; and a first conductive wire member fixed to one side of the first electrode bar member, and in which the first conductive wire member includes: a first conductive wire body region; and a plurality of first conductive wire branch regions extending from the first conductive wire body region and provided to be spaced apart from one another.

The second measurement part may include: a second electrode bar member; and a second conductive wire member fixed to one side of the second electrode bar member, and the second conductive wire member may include: a second conductive wire body region; and a plurality of second conductive wire branch regions extending from the second conductive wire body region and provided to be spaced apart from one another.

The first measurement part may further include a first electrode-facing member electrically connected to the first conductive wire branch region and configured to come into contact with the battery B.

The first measurement part may further include a first junction region having a first side joined to the first conductive wire branch region, and a second side joined to the first electrode-facing member.

A third side of the first junction region may be joined to the first electrode bar member.

The second measurement part may further include a second electrode-facing member electrically connected to the second conductive wire branch region and configured to come into contact with the battery B.

The second measurement part may further include a second junction region having a first side joined to the second conductive wire branch region, and a second side joined to the second electrode-facing member.

A third side of the second junction region may be joined to the second electrode bar member.

The first conductive wire branch region may be inserted into the first electrode bar member.

The second conductive wire branch region may be inserted into the second electrode bar member.

The first measurement part may further include a first insulation member provided to surround the first conductive wire member.

The first insulation member may be provided to surround an outer surface of a portion of the first electrode bar member into which the first conductive wire branch region is inserted.

A portion of the first insulation member, which surrounds the outer surface of the first electrode bar member, may have a cross-sectional shape having an open curve.

The second measurement part may further include a second insulation member provided to surround the second conductive wire member.

The second insulation member may be provided to surround an outer surface of a portion of the second electrode bar member into which the second conductive wire branch region is inserted.

A portion of the second insulation member, which surrounds the outer surface of the second electrode bar member, may have a cross-sectional shape having an open curve.

The plurality of first conductive wire branch regions may be provided at equal intervals in a circumferential direction of the first electrode bar member.

The plurality of second conductive wire branch regions may be provided at equal intervals in a circumferential direction of the second electrode bar member.

According to the present disclosure, it is possible to improve the reliability in measuring the impedance of the battery that is the target to be measured.

In addition, according to the present disclosure, it is possible to ensure more stable electrical connection between the electrode of the battery and the device for measuring the physical properties of the battery.

### BRIEF DESCRIPTION OF THE DRAWINGS

FIG. 1 is a side view of a battery measurement device according to the present disclosure.
FIG. 2 is a cross-sectional view illustrating a state in which a first measurement part and a second measurement part are spaced apart from a fixing part in an upward/downward direction in the battery measurement device in FIG. 1.
FIG. 3 is a view illustrating a planar structure of the measurement part of the battery measurement device according to the present disclosure.
FIG. 4 is a view illustrating a state in which an electrode-facing member and a junction region are excluded from the measurement part in FIG. 3.

### DETAILED DESCRIPTION

Hereinafter, a battery measurement device according to the present disclosure will be described with reference to the drawings.

### BATTERY MEASUREMENT DEVICE

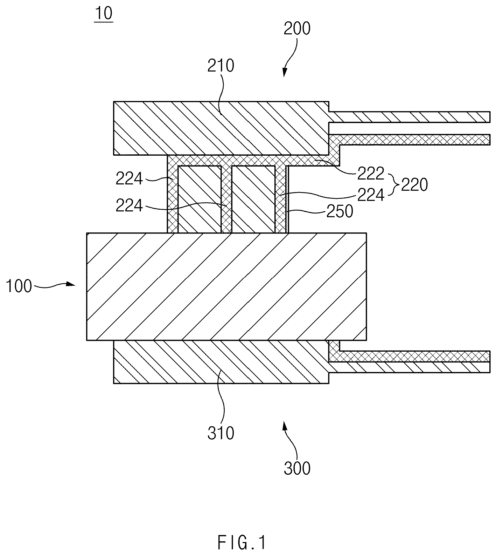

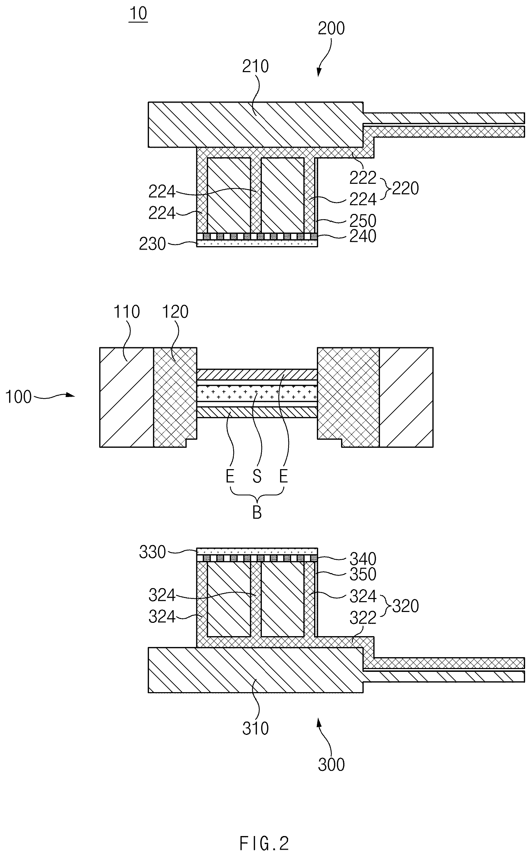

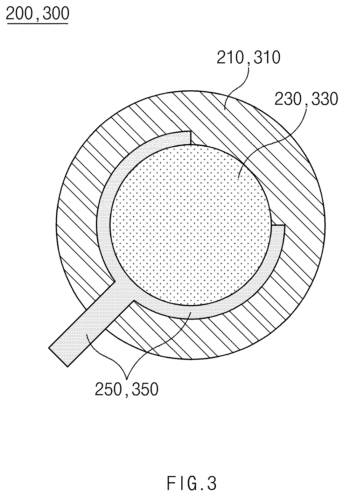

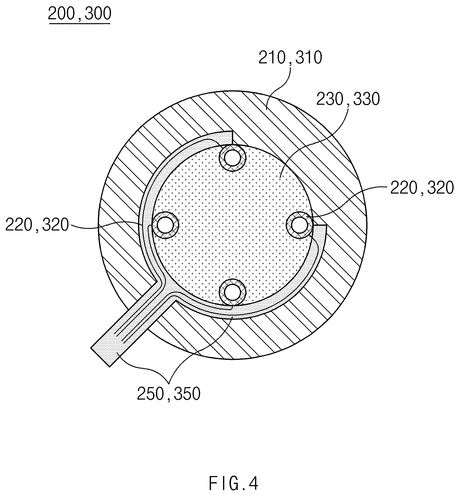

FIG. 1 is a side view of a battery measurement device according to the present disclosure, and FIG. 2 is a cross-sectional view illustrating a state in which a first measurement part and a second measurement part are spaced apart from a fixing part in an upward/downward direction in the battery measurement device in FIG. 1. FIG. 3 is a view illustrating a planar structure of the measurement part of the battery measurement device according to the present disclosure, and FIG. 4 is a view illustrating a state in which an electrode-facing member and a junction region are excluded from the measurement part in FIG. 3.

The battery measurement device according to the present disclosure may serve to measure physical properties of a battery. For example, the battery measurement device according to the present disclosure may serve to measure impedance of a battery. More particularly, the battery measurement device according to the present disclosure may serve to measure impedance of an all-solid-state battery.

A battery B to be measured by the battery measurement device may include a solid electrolyte S and electrodes E provided on two opposite surfaces of the solid electrolyte. The battery measurement device may measure physical properties (e.g., impedance) of the battery B in a state in which the battery measurement device is in contact with the electrodes disposed on two opposite surfaces of the battery B (see FIG. 2).

With reference to FIGS. 1 and 2, a battery measurement device 10 may include a fixing part 100 configured to fix the battery B including the electrodes E and the electrolyte S. The fixing part 100 may be configured to fix the battery B during the process of measuring the physical properties of the battery by using the battery measurement device. For example, the fixing part 100 may include a fixing support part 110 configured to define a peripheral region of the fixing part, and a fixing insulation part 120 provided inside the fixing support part 110 and configured to fix the battery B. The fixing insulation part 120 may be made of an electrically insulating material.

In addition, the battery measurement device 10 may include a first measurement part 200 provided at one side of the fixing part 100 and configured to come into contact with one surface of the battery B, and a second measurement part 300 provided at the other side of the fixing part 100 and configured to come into contact with the other surface of the battery B. For example, as illustrated in FIGS. 1 and 2, the first measurement part 200 and the second measurement part 300 may be respectively provided at upper and lower sides of the fixing part 100. The first measurement part 200 and the second measurement part 300 may be configured to be movable in an upward/downward direction relative to the fixing part 100. However, on the contrary, the first measurement part 200 and the second measurement part 300 may be fixed relative to the fixing part 100. Hereinafter, the first measurement part 200 and the second measurement part 300 will be described.

With continued reference to FIGS. 1 and 2, the first measurement part 200 may include a first electrode bar member 210, and a first conductive wire member 220 fixed to one side of the first electrode bar member 210. In this case, the first conductive wire member 220 according to the present disclosure may have a structure in which a partial region branches off from another region.

More specifically, the first conductive wire member 220 may include a first conductive wire body region 222, and a plurality of first conductive wire branch regions 224 extending from the first conductive wire body region 222 and spaced apart from one another. For example, FIGS. 1 to 4 illustrate that four first conductive wire branch regions 224 branch off from the first conductive wire body region 222. However, the number of first conductive wire branch regions 224 is not limited to the configuration illustrated in the drawings.

Meanwhile, similar to the first measurement part 200, the second measurement part 300 may also have a structure in which a partial region branches off from another region.

More specifically, the second measurement part 300 may include a second electrode bar member 310, and a second conductive wire member 320 fixed to one side of the second electrode bar member 310. The second conductive wire member 320 may include a second conductive wire body region 322, and a plurality of second conductive wire branch regions 324 extending from the second conductive wire body region 322 and spaced apart from one another. For example, FIGS. 1 to 4 illustrate that four second conductive wire branch regions 324 branch off from the second conductive wire body region 322. However, the number of second conductive wire branch regions 324 is not limited to the configuration illustrated in the drawings.

With continued reference to the drawings, the first measurement part 200 may further include a first electrode-facing member 230 electrically connected to the first conductive wire branch regions 224 and configured to come into contact with the battery B. The first electrode-facing member 230 may be configured to come into contact with one side of the battery B (e.g., one surface of the electrode) during the process in which the battery measurement device 10 according to the present disclosure measures the physical properties of the battery.

In addition, the first measurement part 200 may further include a first junction region 240 having a first side joined to the first conductive wire branch regions 224, and a second side joined to the first electrode-facing member 230. The first conductive wire member 220 including the first conductive wire branch regions 224 may be made of a material (e.g., copper or aluminum) having electrical conductivity, whereas the first electrode-facing member 230 may be made of a material (e.g., stainless steel or tungsten) having corrosion resistance. In this case, because the first conductive wire member 220 and the first electrode-facing member 230 are made of different materials, the first conductive wire member 220 and the first electrode-facing member 230 may be hardly fixed directly to each other by welding or the like. The first junction region 240 may be configured to serve to mediate the fixation between the first conductive wire member 220 and the first electrode-facing member 230. More particularly, as illustrated in FIG. 2, a third side of the first junction region 240 may be joined to the first electrode bar member 210.

In addition, similar to the first measurement part, the second measurement part 300 may further include a second electrode-facing member 330 electrically connected to the second conductive wire branch regions 324 and configured to come into contact with the battery B. The second electrode-facing member 330 may be configured to come into contact with one side of the battery B (e.g., one surface of the electrode) during the process in which the battery measurement device 10 according to the present disclosure measures the physical properties of the battery. In this case, the electrode, with which the first electrode-facing member 230 is to be brought into contact, and the electrode, with which the second electrode-facing member 330 is to be brought into contact, may have different polarities.

In addition, the second measurement part 300 may further include a second junction region 340 having a first side joined to the second conductive wire branch regions 324, and a second side joined to the second electrode-facing member 330. The second conductive wire member 320 including the second conductive wire branch regions 324 may be made of a material (e.g., copper or aluminum) having electrical conductivity, whereas the second electrode-facing member 330 may be made of a material (e.g., stainless steel or tungsten) having corrosion resistance. In this case, because the second conductive wire member 320 and the second electrode-facing member 330 are made of different materials, the second conductive wire member 320 and the second electrode-facing member 330 may be difficult to fix directly to each other by welding or the like. The second junction region 340 may be configured to serve to mediate the fixation between the second conductive wire member 320 and the second electrode-facing member 330. More particularly, as illustrated in FIG. 2, a third side of the second junction region 340 may be joined to the second electrode bar member 310.

Meanwhile, with reference to FIGS. 3 and 4, the first conductive wire branch regions 224 may be inserted into the first electrode bar member 210, and the second conductive wire branch regions 324 may be inserted into the second electrode bar member 310.

In addition, the first measurement part 200 may further include a first insulation member 250 provided to surround the first conductive wire member 220. The first insulation member 250 may include or be made of an electrically insulating material. In this case, as illustrated in FIGS. 2 to 4, the first insulation member 250 may be provided to surround an outer surface of a portion of the first electrode bar member 210 into which the first conductive wire branch regions 224 are inserted. More particularly, as illustrated in FIG. 4, a portion of the first insulation member 250, which surrounds the outer surface of the first electrode bar member 210, may have a cross-sectional shape having an open curve. For example, in FIG. 4, the portion of the first electrode bar member 210, which has the outer surface surrounded by the first insulation member 250, may have an approximately cylindrical shape, and the portion of the first insulation member 250, which surrounds the outer surface of the first electrode bar member 210, may surround the outer surface of the first electrode bar member 210 by about 270 degrees based on a central axis of the cylindrical shape.

Meanwhile, similar to the first measurement part, the second measurement part 300 may further include a second insulation member 350 provided to surround the second conductive wire member 320. The second insulation member 350 may include or be made of an electrically insulating material. In this case, as illustrated in FIGS. 2 to 4, the second insulation member 350 may be provided to surround an outer surface of a portion of the second electrode bar member 310 into which the second conductive wire branch regions 324 are inserted. More particularly, as illustrated in FIG. 4, a portion of the second insulation member 350, which surrounds the outer surface of the second electrode bar member 310, may have a cross-sectional shape having an open curve. For example, in FIG. 4, the portion of the second electrode bar member 310, which has the outer surface surrounded by the second insulation member 350, may have an approximately cylindrical shape, and the portion of the second insulation member 350, which surrounds the outer surface of the second electrode bar member 310, may surround the outer surface of the second electrode bar member 310 by about 270 degrees based on a central axis of the cylindrical shape.

Meanwhile, for example, as illustrated in FIG. 4, the plurality of first conductive wire branch regions 224 may be provided at equal intervals in a circumferential direction of the first electrode bar member 210, and the plurality of second conductive wire branch regions 324 may be provided at equal intervals in a circumferential direction of the second electrode bar member 310.

With the above-mentioned configurations, according to the present disclosure, the conductive wire member provided in the measurement part of the battery measurement device may have the plurality of conductive wire branch regions, thereby improving the reliability in measuring the impedance of the battery that is a target to be measured. In particular, according to the present disclosure, the battery measurement device may include the plurality of conductive wire branch regions, thereby improving the reliability of the impedance values of the battery measured at high frequencies.

In addition, according to the present disclosure, the junction region configured to electrically connect different types of materials may be further provided, such that the conductive wire member and the electrode of the battery may be electrically connected more stably.

The present disclosure has been described with reference to the limited embodiments and the drawings, but the present disclosure is not limited thereby. The present disclosure may be carried out in various forms by those skilled in the art, to which the present disclosure pertains, within the technical spirit of the present disclosure and the scope equivalent to the appended claims.

## Claims

1. A battery measurement device comprising:
a fixing part configured to fix a battery (B) comprising an electrode (E) and an electrolyte (S);
a first measurement part provided at one side of the fixing part and configured to come into contact with one surface of the battery (B); and
a second measurement part provided at another side of the fixing part and configured to come into contact with another surface of the battery (B),
wherein the first measurement part comprises:
a first electrode bar member; and
a first conductive wire member fixed to one side of the first electrode bar member, and
wherein the first conductive wire member comprises:
a first conductive wire body region; and
a plurality of first conductive wire branch regions extending from the first conductive wire body region and provided to be spaced apart from one another.

2. The battery measurement device of claim 1, wherein the second measurement part comprises:
a second electrode bar member; and
a second conductive wire member fixed to one side of the second electrode bar member, and
wherein the second conductive wire member comprises:
a second conductive wire body region; and
a plurality of second conductive wire branch regions extending from the second conductive wire body region and provided to be spaced apart from one another.

3. The battery measurement device of claim 1 or 2, wherein the first measurement part further comprises a first electrode-facing member electrically connected to the plurality of first conductive wire branch regions and configured to come into contact with the battery (B).

4. The battery measurement device of claim 3, wherein the first measurement part further comprises a first junction region having a first side joined to the plurality of first conductive wire branch regions, and a second side joined to the first electrode-facing member.

5. The battery measurement device of claim 4, wherein a third side of the first junction region is joined to the first electrode bar member.

6. The battery measurement device of claim 2, or of anyone of claims 3-5 provided that in combination with claim 2, wherein the second measurement part further comprises a second electrode-facing member electrically connected to the plurality of second conductive wire branch regions and configured to come into contact with the battery (B).

7. The battery measurement device of claim 6, wherein the second measurement part further comprises a second junction region having a first side joined to the plurality of second conductive wire branch regions, and a second side joined to the second electrode-facing member.

8. The battery measurement device of claim 7, wherein a third side of the second junction region is joined to the second electrode bar member.

9. The battery measurement device of anyone of claims 1-8, wherein the plurality of first conductive wire branch regions are inserted into the first electrode bar member.

10. The battery measurement device of claim 2, or of anyone of claims 3-9 provided that in combination with claim 2, wherein the plurality of second conductive wire branch regions are inserted into the second electrode bar member.

11. The battery measurement device of anyone of claims 1-10, wherein the first measurement part further comprises a first insulation member provided to surround the first conductive wire member.

12. The battery measurement device of claim 11, wherein the first insulation member is provided to surround an outer surface of a portion of the first electrode bar member into which the plurality of first conductive wire branch regions are inserted.

13. The battery measurement device of claim 12, wherein a portion of the first insulation member, which surrounds the outer surface of the first electrode bar member, has a cross-sectional shape with an open curve.

14. The battery measurement device of claim 2, or of anyone of claims 3-13 provided that in combination with claim 2, wherein the second measurement part further comprises a second insulation member provided to surround the second conductive wire member.

15. The battery measurement device of claim 14, wherein the second insulation member is provided to surround an outer surface of a portion of the second electrode bar member into which the plurality of second conductive wire branch regions are inserted.
